(19)

**Europäisches Patentamt**
**European Patent Office**
**Office européen des brevets**

(11) **EP 2 242 111 A1**

(12) **EUROPEAN PATENT APPLICATION**
published in accordance with Art. 153(4) EPC

(43) Date of publication:
**20.10.2010 Bulletin 2010/42**

(51) Int Cl.:
**H01L 31/04** *(2006.01)*

(21) Application number: **09708095.6**

(22) Date of filing: **06.02.2009**

(86) International application number:
**PCT/JP2009/052109**

(87) International publication number:
**WO 2009/099217 (13.08.2009 Gazette 2009/33)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **06.02.2008 JP 2008026601**

(71) Applicant: **Kyocera Corporation**
**Kyoto-shi**
**Kyoto 612-8501 (JP)**

(72) Inventors:
• **NIIRA, Koichiro**
**Higashiomi-shi**
**Shiga 527-8555 (JP)**

• **NISHIMURA, Takehiro**
**Higashiomi-shi**
**Shiga 527-8555 (JP)**
• **ITO, Norikazu**
**Higashiomi-shi**
**Shiga 527-8555 (JP)**
• **INABA, Shinichiro**
**Higashiomi-shi**
**Shiga 527-8555 (JP)**

(74) Representative: **Witte, Weller & Partner**
**Königstrasse 5**
**70173 Stuttgart (DE)**

(54) **PROCESS FOR PRODUCING SOLAR BATTERY ELEMENT AND SOLAR BATTERY ELEMENT**

(57)     Provided is a superstrate type a-Si:H thin film solar cell of which the device characteristics are improved as compared with conventional ones. The solar cell device is manufactured by a process comprising depositing phosphorus on a transparent conductive film formed on a transparent substrate and sequentially forming a p-type layer, an i-type layer, and an n-type layer which are formed of a-Si:H on the transparent conductive film by a plasma CVD method. The phosphorus is deposited, for example, by plasmatization of phosphorus-containing gas. Alternatively, the phosphorus is deposited by etching a phosphorus source provided in a margin region where a plasma excitation voltage is applied but no transparent substrate is placed, with hydrogen plasma at the start of the formation of the p-type layer by the plasma CVD method. Preferably, the deposition of phosphorus is controlled so that the arithmetic average value ($\Delta$Cav) of the concentration difference between boron and phosphorus within a range of diffusion of boron in the i-type layer may be

$$1.1 \times 10^{17}\ (\mathrm{cm}^{-3}) \leq \Delta\mathrm{Cav} \leq 1.6 \times 10^{17}\ (\mathrm{cm}^{-3})\ \text{or less.}$$

**(Cont. next page)**

FIG. 6

(a)

(b)

**Description**

Technical Field

The present invention relates to a thin film solar cell, and more particularly to a thin film solar cell having a p-i-n junction structure formed of an amorphous material of which the main component is silicon.

Background Art

Thin film solar cells each have a p-i-n junction structure in which a p-type layer (p conductivity type semiconductor layer), an i-type layer (undoped semiconductor layer), an n-type layer (n conductivity type semiconductor layer) each of which is formed of a a-Si:H film are stacked on a substrate by a plasma CVD method.

Thin film solar cells are broadly divided into a substrate type and a superstrate type from the viewpoint of an arrangement relation between a film structure in which the p-type layer side coincides with a light incident side and a substrate. When the p-type layer is arranged on the light incident side, a substrate type thin film solar cell has a structure in which an electrode layer is formed on a support substrate, silicon films constituting an n-type layer, an i-type layer, and a p-type layer are formed thereon in this order, and then a transparent electrode layer is stacked thereon. On the other hand, a superstrate type thin film solar cell has a structure in which silicon films constituting a p-type layer, an i-type layer, and an n-type layer are formed in this order on a conductive substrate having a glass substrate and a transparent conductive film formed on the glass substrate, and then an electrode layer is stacked thereon.

In these thin film solar cells, due to the diffusion of a dopant into the i-type layer from the n-type layer (in the substrate type one) or from the p-type layer (in the superstrate type one) in a film formation process using the plasma CVD method, the electric field at an n/i interface (in the substrate type one) or a p/i interface (in the superstrate type one) becomes insufficient and the efficiency of the separation of carriers generated near the p/i interface decreases, and this causes a loss of the characteristics (e.g., decrease in the current density Jsc) of the solar cells.

Techniques for solving the degradation of the characteristics due to the diffusion of the dopant are well known by Japanese Patent Application Laid Open Gazette No. 07-263728 (Patent Document 1) and Japanese Patent Application Laid Open Gazette No. 09-223807 (Patent Document 2).

Further, attention is being directed to a tandem-type thin film solar cell in which a p-i-n junction structure unit formed of a-Si:H having a wide bandgap is formed on the light incident side, where a p-type layer, an i-type layer, and an n-type layer are formed in this order from the light incident side, and another p-i-n junction structure unit formed of $\mu$c-Si having a narrow bandgap is formed, where a p-type layer, an i-type layer, and an n-type layer are formed in this order from the light incident side. In the tandem-type thin film solar cell, the units each have a superstrate type structure.

Patent Document 1 discloses a technique to solve the degradation of the characteristics of the substrate type a-Si:H thin film solar cell by counter doping. In this technique, boron is uniformly doped during the formation of the i-type layer and the effect of phosphorus diffused from the n-type layer therebelow into the i-type layer is thereby cancelled. This uniformizes the internal electric field in the i-type layer as much as possible, to thereby solve the decrease in the current density Jsc. Patent Document 1 also discloses another technique in which, after the formation of the n-type layer, gas containing boron is brought into contact on a surface of the n-type layer to deposit boron and then the i-type layer is formed, instead of the counter doping method.

Patent Document 2 proposes a technique for the substrate type a-Si:H thin film solar cell. In this technique, after the formation of the n-type layer, a very thin silicon layer (having a thickness of about 8 nm) into which boron is mixed, which is referred to as a barrier layer, is formed and then the i-type layer is formed. Even if the techniques disclosed in Patent Documents 1 and 2 are applied to a superstrate type a-Si:H thin film solar cell, however, a sufficient effect cannot be produced.

As discussed in Japanese Patent Application Laid Open Gazette No. 2004-31518 (Patent Document 3), it is known that the degradation of the characteristics is caused by the same reason also in a thin film solar cell formed of microcrystalline silicon (hereinafter, referred to as "$\mu$c-Si"). Even if the technique disclosed in Patent Document 3 is applied to a superstrate type a-Si:H thin film solar cell, however, a sufficient effect cannot be produced.

Disclosure of Invention

The present invention is intended to solve the above problem, and it is an object of the present invention to provide a thin film solar cell of which the device characteristics are improved as compared with conventional ones.

According to a preferred embodiment of the present invention, a method of manufacturing a solar cell device comprises the steps of preparing a transparent substrate with a transparent conductive film, depositing an n-type dopant on the transparent conductive film, and sequentially forming a p-type layer, an i-type layer, and an n-type layer on the transparent conductive film.

In the solar cell device, the n-type dopant thereby passes through an interface between the transparent conductive film and the p-type layer and the inside of the p-type layer and reaches an interface between the p-type layer and the i-type layer and further is diffused (tails) into the i-type layer. Since the effect of the diffusion of a p-type dopant from the p-type layer into the i-type layer is cancelled by the diffusion of the n-type dopant, it is possible to achieve a superstrate type solar cell device having excellent characteristics with high current density.

Brief Description of Drawings

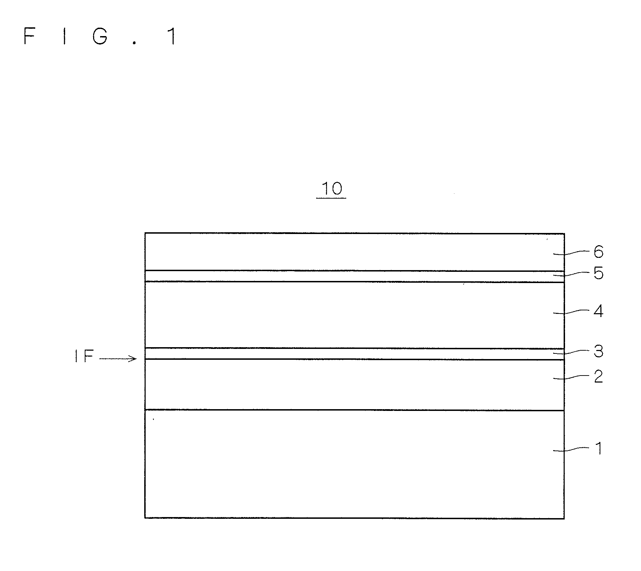

[Fig. 1] is a schematic cross section showing a solar cell device 10;
[Fig. 2] is a view schematically showing a cross-sectional structure of the solar cell device in a case where a transparent conductive layer 2 having fine projections and depressions on its surface is formed on a flat transparent substrate 1 and then layers including a p-type layer 3 are formed thereon;
[Fig. 3] is a schematic view illustrating a configuration of a plasma CVD film formation apparatus 100;
[Fig. 4] is a graph showing a result of SIMS analysis on the solar cell device 10 having been subjected to an n-type dopant introduction process in accordance with a first aspect;
[Fig. 5] is a graph showing a result of SIMS analysis on the solar cell device 10 having been subjected to the n-type dopant introduction process in accordance with a second aspect;
[Fig. 6] shows schematic views representing concentration distributions of boron and phosphorus in the solar cell device 10 and a solar cell device in which a barrier layer is provided at an interface between the p-type layer and the i-type layer;
[Fig. 7] is a graph showing (averaged) concentration distributions of boron and phosphorus in a depth direction on the basis of the SIMS analysis; and
[Fig. 8] is a graph showing a relation between a concentration difference arithmetic average value $\Delta$Cav and current density Jsc of a plurality of solar cell devices 10 having been subjected to the n-type dopant introduction process under various conditions in accordance with the first aspect.

Best Mode for Carrying Out the Invention

<Outline of Solar Cell Device>

A solar cell device 10 has a structure in which a transparent conductive layer 2, a p-type layer 3, an i-type layer 4, an n-type layer 5, and an electrode layer 6 are stacked in this order on a transparent substrate 1 such as a glass substrate or the like. Hereinafter, the p-type layer 3, the i-type layer 4, and n-type layer 5 are generally referred to as a silicon thin film layer in some cases.
The transparent conductive layer 2 is formed of, e.g., $SnO_2$ and has a thickness of about 500 nm to 1 $\mu$m. The transparent conductive layer 2 can be formed by, e.g., a thermal CVD method or a sputtering method.
The p-type layer 3 is a p conductivity type semiconductor layer and has a thickness of about several nm to 20 nm. The p-type layer 3 has a structure in which, for example, a-Si:H film is doped with boron (B) as a dopant with a concentration of about $10^{19}$ to $10^{21}$ (cm$^{-3}$).
The i-type layer 4 is an undoped semiconductor layer functioning as a photoactive layer and has a thickness of about 200 nm to 300 nm. The i-type layer 4 is formed of, e.g., an a-Si:H film. In this preferred embodiment, however, even the i-type layer 4 doped with an n-type dopant of about $1 \times 10^{16}$/cm$^3$ or less or being slightly n-type because of the presence of an internal defect is also regarded to be substantially i-type. It is desirable that the i-type layer 4 should contain an n-type dopant of about $5 \times 10^{15}$/cm$^3$ or less. A p-type dopant may be doped in the i-type layer 4 so as to cancel the development of the conductivity due to the internal defect.
The n-type layer 5 is an n conductivity type semiconductor layer and has a thickness of about several nm to 20 nm. The n-type layer 5 has a structure in which, for example, an a-Si:H film is doped with phosphorus (P) as a dopant with a concentration of about $10^{19}$ to $10^{21}$ (cm$^{-3}$).
The electrode layer 6 is constituted of two layers, e.g., a transparent conductive layer and a Ag film. The electrode layer 6 is formed by, e.g., a sputtering method to have an appropriate thickness.
The solar cell device 10 of this preferred embodiment is a superstrate type thin film solar cell in which electromotive force generated by photoelectric conversion of light incident from the side of the transparent substrate 1 is taken out by electrodes connected to the electrode layer 6 and the transparent conductive layer 2. In order to reduce the diffusion of boron from the p-type layer, a buffer layer formed of amorphous Si or amorphous SiC may be provided between the p-type layer 3 and the i-type layer 4.
In the solar cell device 10 of this preferred embodiment, the p-type layer is arranged on the light incident side.

The reason is that, since the i-type layer is an undoped layer but the physical properties thereof is slightly n-type, the electric field strength is higher at an interface between the p-type layer and the i-type layer than at an interface between the n-type layer and the i-type layer, and therefore, the carrier recombination velocity can be lowered by forming the interface between the p-type layer and the i-type layer on the light incident side where more photoexcited carriers are generated. Further, minority carriers can become electrons having higher mobility.

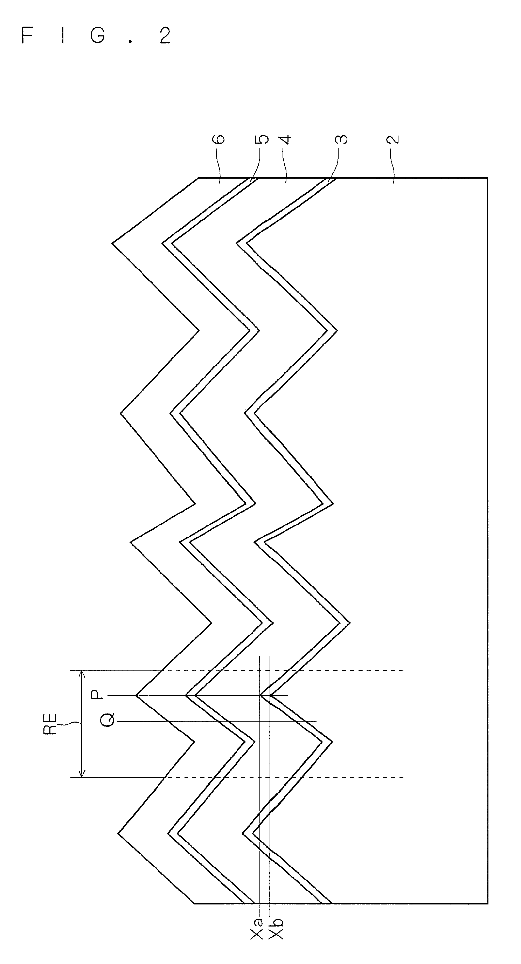

Furthermore, in the solar cell device 10, the transparent conductive layer 2 may have fine asperities on its surface (see Fig. 2), for example, in a process of forming the transparent conductive layer 2 on the not-shown flat transparent substrate 1. If the transparent conductive layer 2 has the asperities on its surface, the layers to be formed on the transparent conductive layer 2 have asperities. Alternatively, fine asperities may be formed on a surface of the transparent substrate 1. It is favorable that the asperities should have an average height of about 100 to 200 nm and an average cycle of about 100 to 200 nm.

In the case where asperities are formed, since the light incident from the side of the transparent substrate 1 into the solar cell device 10 is scattered, the optical path length in the i-type layer 4 increases and the output of the solar cell further increases.

<Plasma CVD Film Formation Apparatus>

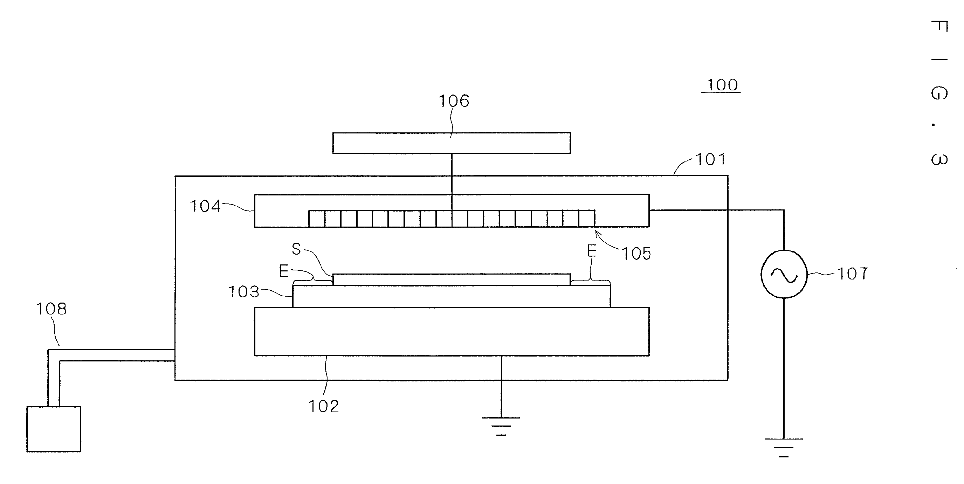

The silicon thin film layer of the solar cell device 10 can be formed by using a plasma CVD apparatus. The plasma CVD apparatus 100 shown in Fig. 3 is a parallel plate plasma CVD apparatus. As the plasma CVD apparatus 100, for example, a general-type plasma CVD apparatus in which film formation is performed by plasmatization of a source gas, such as an inductively coupled plasma CVD apparatus, a microwave plasma CVD apparatus, or the like, can be used.

In the parallel plate plasma CVD apparatus 100, an underlying substrate S which is a substrate on which a film is to be formed is placed on a tray 103 provided on a lower electrode 102 inside a reaction chamber 101. The underlying substrate S can be heated by a heating means to a predetermined temperature required to form a film. In the reaction chamber 101, an upper electrode 104 is provided in parallel to the lower electrode 102. The upper electrode 104 is a showerhead electrode provided with a lot of source gas introduction ports 105. A source gas supplied from a gas source 106, in accordance with the composition of the film to be formed, is introduced through the source gas introduction port 105 into the reaction chamber 101. A predetermined plasma excitation voltage can be applied to the upper electrode by a high-frequency power supply 107. A depressurization means 108 such as a vacuum pump is provided in order to depressurize the inside of the reaction chamber 101.

In a process of forming the silicon thin film layer, silane ($SiH_4$) gas diluted with hydrogen ($H_2$) gas is supplied as a source gas. In order to form the p-type layer 3 and the n-type layer 5, $B_2H_6$ gas and $PH_3$ gas are further mixed, respectively, as dopant gases.

< Diffusion of Phosphorus from Transparent Conductive Layer/P-type Layer Interface>

In the superstrate type solar cell device 10 of this preferred embodiment, part of boron doped in the p-type layer 3 is diffused into the i-type layer 4. In the process of forming the silicon thin film layer by the plasma CVD method, during the film formation, a film surface is always exposed to plasma. For this reason, even if it appears that only the deposition of the film takes place, but focusing on the film surface, the film growth is proceeding in situation that etching and deposition constantly take place at the same time,. Therefore, during the formation of the i-type layer, the dopant in a layer below the surface of the growing film is mixed into the growing i-type layer thereabove and tailing of boron into the i-type layer 4 thereby occurs. In this preferred embodiment, at some midpoint in the process of manufacturing the solar cell device 10, an n-type dopant introduction process is performed prior to the formation of the p-type layer 3. This reduces the degradation of the characteristics of the solar cell device due to the diffusion of the dopant.

The n-type dopant introduction process refers to a process in which at the start of the formation of the p-type layer 3, only a very small quantity of phosphorus which is an n-type dopant is deposited on a surface of the transparent conductive layer 2. The deposition of phosphorus is controlled so that the concentration of phosphorus to be distributed in the p-type layer 3 by the following diffusion may be smaller by one order or more than the concentration of boron to be doped in the p-type layer 3. This avoids reduction of the function of the p-type layer 3.

The solar cell device 10 that the p-type layer 3 is formed after performing the n-type dopant introduction process like this can obtain current density Jsc higher than that of the solar cell device manufactured with no n-type dopant introduction process. For example, the solar cell device 10 which is manufactured by using an uncleaned tray after forming a p-i-n junction structure unit thereon therebefore can increase the current density Jsc as compared with the solar cell device which is manufactured by using a cleaned tray.

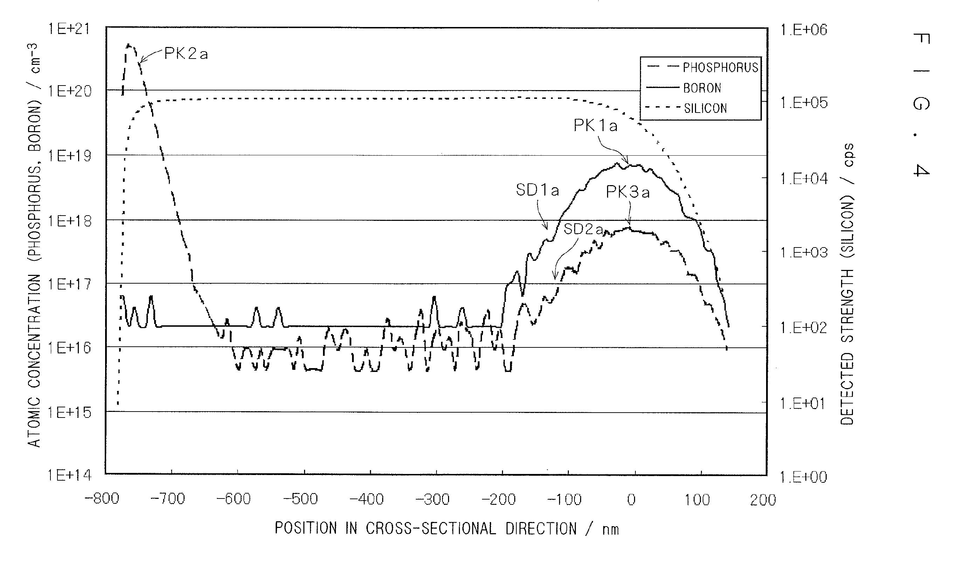

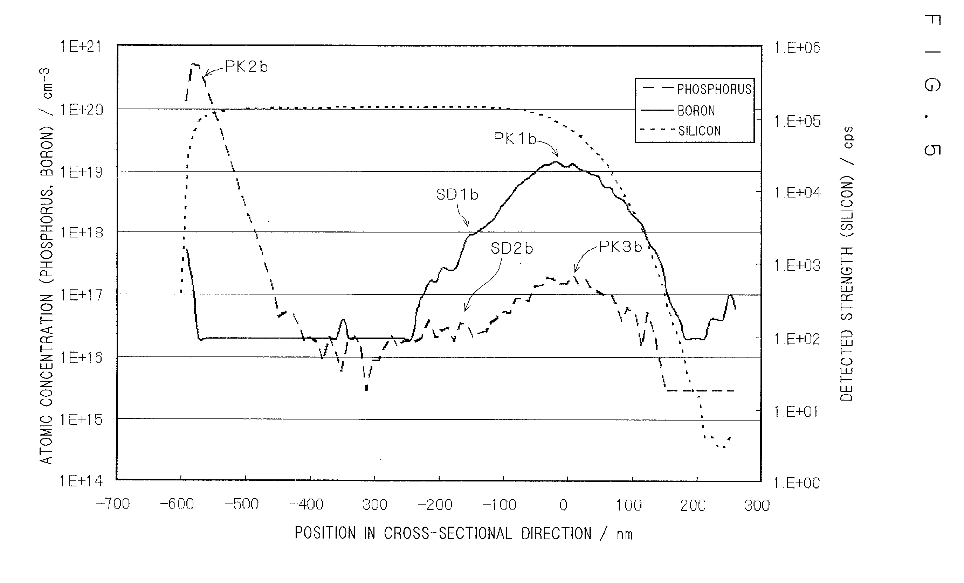

Figs. 4 and 5 each shows a result (showing a relation between the etching depth and the detected strength as analyzed from the side of the electrode layer 6) of SIMS (Secondary Ion Mass Spectrometry) analysis in a depth direction of the solar cell device 10 having been subjected to the n-type dopant introduction process. Hereinafter, in Figs. 4 and 5, the horizontal axis is defined as the x axis and the vertical axis is defined as the y axis. The numerical values in the horizontal axis of Figs. 4 and 5 are rough standard values, not absolute ones. In Figs. 4 and 5, the x-axis negative direction (from the right side of these figures toward the left side) is a direction where the transparent conductive layer 2, the p-type layer 3, the i-type layer 4, and the n-type layer 5 are formed in this order. In both cases, the solar cell device 10 in which the asperities was formed on the surface of the transparent conductive layer 2 in advance was used as a target analyte.

In the case of Fig. 4, used was the solar cell device 10 whose silicon thin film layer was formed through plasmatization of the surface of the transparent conductive layer 2 with introduction of a phosphorus-containing gas before the formation of the p-type layer 3 in the reaction chamber 101 as the n-type dopant introduction process.

In the case of Fig. 5, used was the solar cell device 10 whose silicon thin film layer was formed by employing the way of using the tray 103 having been used for the formation of the p-i-n junction unit without cleaning as it is, as the n-type dopant introduction process.

In both solar cell devices 10, the thickness of the p-type layer 3 is 8 nm, that of the i-type layer 4 is 300 nm, and that of the n-type layer 5 is 20 nm. Further, the buffer layer having a thickness of about 5 nm and made of amorphous SiC is formed between the p-type layer 3and the i-type layer 4. In Figs. 4 and 5, the respective concentrations (atomic concentrations) of boron and phosphorus are represented by concentration values contained in silicon, which is obtained on the basis of the calibration curve measured by using reference samples in advance.

In Figs. 4 and 5, at the position of x = 0, the broad peaks PK1a and PK1b of boron can be seen (actually, the position of the broad peak is defined as the x-axis origin). The broad peaks are caused by boron doped in the p-type layer 3 as a dopant. In the process of forming the p-type layer 3, since $B_2H_6$ gas which is a dopant gas in constant amount is always supplied together with the source gas, the boron concentration at least in the p-type layer 3 must be constant in the depth direction. In Figs. 4 and 5, however, it is difficult to specify the portions corresponding thereto, and the peak PK1a which occupies a very wide range as compared with the thickness of the p-type layer 3, i.e., 8 nm is only found. As to silicon which originally shows a sharp change of concentration at an interface between the transparent conductive layer 2 and the p-type layer 3, a gradual change is found in the range of -50 nm $\leq$ x $\leq$ 200 nm.

As one of the causes for these phenomena, since the SIMS analysis is performed on the solar cell device 10 having such structure of asperity as shown in Fig. 2, spatial height positions of the layers in the depth direction in the analysis region vary depending on the analysis position and not constant in the analysis region. In a case where the SIMS analysis is performed on an analysis region RE of which the cross section is shown in Fig. 2, for example, sputtering is performed from the upside toward the downside in a thickness direction to perform the analysis in the depth direction. In this case, at the position Xa in the depth direction, the analysis region RE does not entirely reach the p-type layer 3 and only the local position P and its vicinity reach the p-type layer 3. In the analysis region, there are portions, such as the local position Q, which reach the i-type layer 4. Therefore, the concentration value to be obtained is a value obtained by superimposing the information for the p-type layer 3 on the information for the i-type layer 4. At the position Xb and later, the information for the transparent conductive layer 2 is also superimposed thereon. In view of this fact, it is understood that Figs. 4 and 5 each show a result obtained by averaging the concentration distributions in the depth direction at all the points in the analysis region with respect to the analysis region.

The peak PK1a for boron, however, is found in the range of x $\geq$ about -200 nm in Fig. 4 and in the range of x $\geq$ about -240 nm in Fig. 5, and in the range on the left side from the above ranges in these figures, the boron concentration falls to almost the background level. In Fig. 4, at the position of x = about -760 nm, the peak PK2a of phosphorus is found and in the range of x $\geq$ about -600 nm, the phosphorus concentration falls to the background level. Similarly, in Fig. 5, at the position of x = about -580 nm, the peak PK2b of phosphorus is found and in the range of x $\geq$ about -400 nm, the phosphorus concentration falls to the background level. These peaks PK2a and PK2b are obtained by phosphorus doped in the n-type layer 5.

In Figs. 4 and 5, on the left half side of the peaks PK1a and PK1b for boron, shoulders (respective shoulders of the peaks) SD1a and SD1b are found. These shoulders are caused by the tailing of boron from the p-type layer 3 to the i-type layer 4. The position where the shoulder SD1a is formed is an average start position of the tailing of boron. Since the distance of the tailing which can be seen from Figs. 4 and 5 is sufficiently larger as compared with the thickness of the buffer layer, it is understood that the amount of diffused boron is reduced by the presence of the buffer layer but boron reaches the i-type layer 4. Therefore, both Figs. 4 and 5 show that boron is diffused up to the side of the i-type layer 4 from the average start position.

On the other hand, paying attention to the profiles of phosphorus in Figs. 4 and 5, the profiles have the peaks PK3a and PK3b at almost the same position as the peaks PK1a and PK1b of boron, not only the peaks PK2a and PK2b. The shoulders SD2a and SD2b are formed at almost the same positions as the shoulders SD1a and SD1b. It is thought that these are concentration distributions resulting from the deposition of phosphorus atoms on the surface of the transparent conductive layer 2 in the n-type dopant introduction process. Also on the side of the i-type layer 4 from the average start position of the tailing of boron, phosphorus is detected with the concentration slightly larger than that at the background position.

Since it is understood that the phosphorus which is thus diffused into the i-type layer 4 cancels the effect of the boron which is also diffused into the i-type layer 4, the substantial boron (B) doping concentration (acceptor concentration) (other than that compensated by phosphorus) becomes sharp at the p/i interface and the electric field strength in the i-type layer near the interface thereby increases. As a result, high current density Jsc can be achieved.

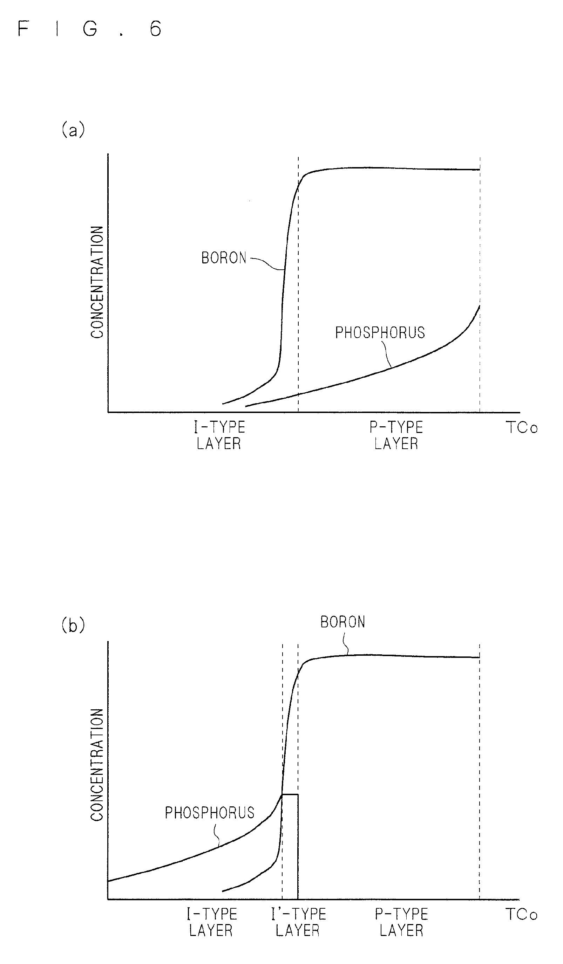

As to the effect of the diffusion of phosphorus into the i-type layer 4, the current density Jsc cannot be sufficiently increased by supplying phosphorus between the p-type layer 3 and the i-type layer 4. Fig. 6(a) schematically shows the distributions of boron and phosphorus in the depth direction at a point such as represented by the vertical line at the point Q in Fig. 2. In this case, since theoretical values, for example, on linear points along the vertical line at the point Q shown in Fig. 2, instead of the SIMS analysis values, are shown, there is no effect of the above-discussed structure of asperity, and the concentration of boron in the p-type layer is almost constant and part of boron is diffused into the i-type layer. On the other hand, since phosphorus is diffused little by little from the interface between the transparent conductive layer and the p-type layer toward the i-type layer, it is thought that, consequently, phosphorus has such a concentration distribution as shown in Fig. 6(a). The diffusion range of phosphorus is wider than that of boron.

On the other hand, Fig. 6(b) schematically shows the distributions of boron and phosphorus in the depth direction at a certain point in a case of fabricating a solar cell device such that an i'-type layer formed of silicon doped with phosphorus is provided between the p-type layer and the i-type layer. In this case, though boron is diffused to the i'-type layer and further to the i-type layer and phosphorus is also diffused from the i'-type layer to the i-type layer, since phosphorus is diffused more widely than boron in the i-type layer, phosphorus is widely distributed in the i-type layer. In this case, the function of the i-type layer as a photoactive layer is consequently weakened, and since an ideal distribution of the electric field strength at the p/i interface cannot be obtained, the current density Jsc does not increase.

In the solar cell device 10 of this preferred embodiment, in the process of manufacturing the superstrate type thin film solar cell in which the thin film layer is formed of amorphous silicon, the n-type dopant introduction process is performed prior to the formation of the p-type layer 3, phosphorus is diffused from the interface between the transparent conductive layer 2 and the p-type layer 3 to the p-type layer 3 and further to the i-type layer 4, and the phosphorus desirably cancels the effect of boron in the i-type layer 4. Therefore, it is thereby possible to achieve a superstrate type solar cell device having more excellent characteristics than conventional ones.

<N-type Dopant Introduction Process>

Next, discussion will be made below on the n-type dopant introduction process.

<The First Method: Plasma Processing>

In order to form the silicon thin film layer by using the plasma CVD film formation apparatus 100, first, the transparent substrate 1 on which the transparent conductive layer 2 was formed is placed on the lower electrode 102 in the reaction chamber 101 and heated by a heater. Next, the depressurization means 108 vacuum-depressurizes the inside of the reaction chamber 101. After that, a $PH_3$-$H_2$ mixed gas (obtained by diluting $PH_3$ gas which is an n-type dopant supply gas with $H_2$ gas) serving as a process gas is introduced form the source gas introduction port 105 of the upper electrode 104 into the reaction chamber 101. Then, the high-frequency power supply 107 applies a voltage to the lower electrode 102 and the upper electrode 104 to carry out the plasmatization of the $PH_3$-$H_2$ gas, to thereby deposit the n-type dopant (phosphorus atoms) on the surface of the transparent conductive layer 2. In the first method, by appropriately controlling the dilution rate of the gas and the plasma processing time, the phosphorus concentration toward the interface between the p-type layer 3 and the i-type layer 4 can be controlled. Herein, the expression "to place something on the lower electrode 102" includes "to place something directly on the lower electrode 102" and "to place something on the lower electrode 102 with the tray 103 or the like interposed therebetween".

<The Second Method: Use of Uncleaned Tray>

In the process of forming the silicon thin film layer by using the plasma CVD apparatus 100, the transparent substrate 1 on which the transparent conductive layer 2 was formed is placed as the underlying substrate S on the tray 103 and at that time, a partial region of the tray 103 is exposed, not being covered with the transparent substrate 1. The partial region is referred to as a margin region E. It is said that the margin region E is the region exposed to a plasma space during the film formation but where no transparent substrate 1 is placed.

In the case where the silicon thin film layer is formed on the transparent conductive layer 2 by the plasma CVD film formation apparatus 100 for the manufacture of the superstrate type solar cell device, since the margin region E is not covered, the p-type layer, the i-type layer, and the n-type layer are stacked on the transparent conductive layer 2 and the margin region E.

Usually, the tray 103 on which the layered structure is formed also in the margin region E is cleaned with deposits on the margin region E having been removed before the next use, and used for the next processing. In the second method, however, the tray 103 with the n-type layer formed on its outermost surface of the margin region E (uncleaned tray) is used for the next formation of the solar cell device 10, and the deposition of phosphorus on the transparent conductive layer 2 and the diffusion of phosphorus into the p-type layer 3 and the i-type layer 4 are thereby achieved.

When the silicon thin film layer is formed by using the uncleaned tray 103 for the manufacture of the solar cell device 10, immediately after the start of the film formation, the n-type layer deposited on the surface of the margin region E is etched with hydrogen radical in a plasma atmosphere excited inside a film forming chamber and the phosphorus in the n-type layer is thereby taken in the surface of the transparent conductive layer 2 and the p-type layer 3 in the early stage of the film formation thereof. Concurrently with the ongoing formation of the p-type layer 3 on the surface of the transparent conductive layer 2, however, the p-type layer is formed also on the margin region E of the tray 103, to cover the n-type layer formed on the surface of the margin region E. For this reason, the introduction of phosphorus into the p-type layer 3 which is caused by the etching of the n-type layer formed in the margin region takes place in a limited period immediately after the start of the formation of the p-type layer 3. Therefore, the n-type dopant introduction process can be performed in the early stage of the formation of the silicon thin film layer.

<The Third Method: Placement of Phosphorus-Containing Member>

As another exemplary case of the second method, the formation of the p-type layer 3 may be started with a phosphorus-containing member (e.g., powder containing high purity phosphorus which is put in a small dish of quartz, a pellet of phosphorus, or the like) or the small dish of quartz being placed on the margin region E of the cleaned tray 103. In this case, at the start of the formation of the p-type layer 3, the phosphorus-containing member is reactively etched with hydrogen radical which is a component of a plasma gas and phosphorus is thereby supplied into the plasma gas. As the formation of the p-type layer 3 proceeds, the p-type layer is formed also on the margin region E, to cover the exposed phosphorus-containing member. Therefore, the introduction of phosphorus into the p-type layer 3 takes place in only a limited period immediately after the start of the formation of the p-type layer 3.

In view of efficient etching with hydrogen plasma, it is desirable that the phosphorus-containing member should contain red phosphorus. In order to reduce the occurrence of variation in the phosphorus concentration in the silicon thin film layer of the solar cell device 10, in the case where the phosphorus-containing member is placed on the margin region E, it is desirable that the phosphorus-containing members should be placed in a plurality of portions at regular intervals around the transparent substrate 1.

<The Fourth Method: Placement of N-type Silicon Substrate>

As another exemplary case of the third method, an n-type silicon substrate may be used instead of the phosphorus-containing member.

A favorable example of the n-type silicon substrate is a substrate manufactured by a process, for example, in which a polycrystalline silicon cast block with phosphorus concentration of $1 \times 10^{20}$ ($cm^3$) is fabricated by casting, this block is processed into a silicon substrate having a thickness of about 100 $\mu$m by using a multiwire saw, and then the substrate is crushed. As to the crushing process, it is desirable that the substrate should be crushed by a quartz rod or the like in a mortar of quartz so as to reduce contamination.

<The Fifth Method: Spraying of Phosphoric Acid Solution>

As another exemplary case of the second method, a compound containing phosphorus may be deposited by spraying a phosphoric acid solution on the underlying substrate S or the margin region E of the tray 103 prior to the formation of the silicon thin film layer.

Also in this case, at the start of the formation of the p-type layer 3, the compound containing phosphorus deposited on the surface is reactively etched with hydrogen radical which is a component of the plasma gas and phosphorus is thereby supplied into the plasma gas.

<Optimization of Concentration Difference between Boron and Phosphorus>

In order to further increase the current density Jsc, it is preferable to specify an optimum range of the concentration difference between phosphorus and boron in the i-type layer 4 and control the diffusion states of phosphorus and boron so that the respective concentrations thereof in such a range can be achieved, rather than the separate specification of respective optimum ranges of the concentrations of phosphorus and boron in the i-type layer 4.

In many cases, however, in the solar cell device 10, the layers are formed on the transparent conductive layer 2 having the surface with asperities. In the solar cell device 10, since the concentration distributions can be obtained with the averaged state in the depth direction, the optimum range of the above-discussed concentration difference is estimated on the basis of this concentration distribution.

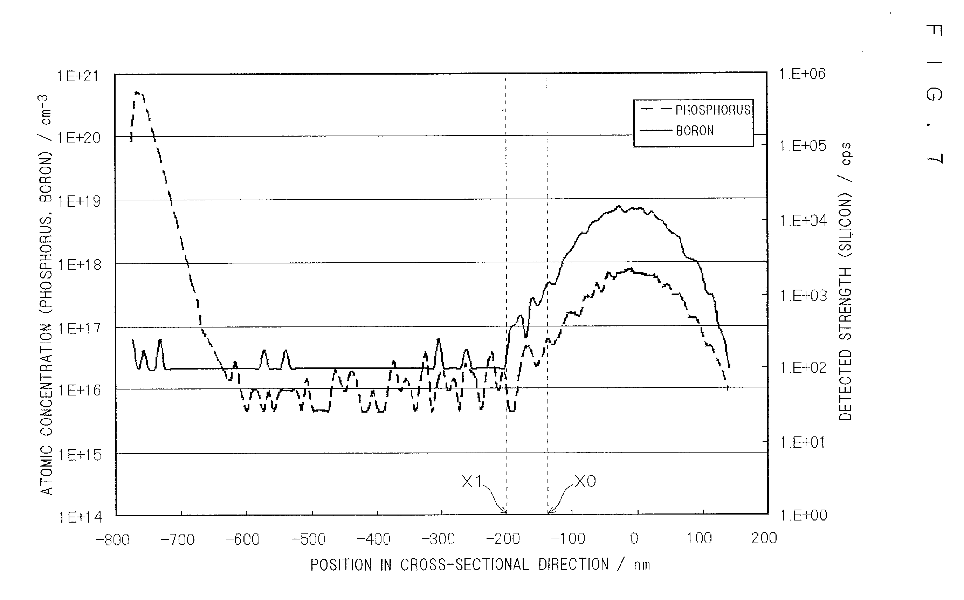

Fig. 7 is a graph showing (averaged) concentration distributions of boron and phosphorus in the depth direction on the basis of the SIMS analysis like that in Fig. 4. The concentration distribution of silicon, however, is omitted. First, discussion will be made on a method of obtaining an evaluation value indicating the concentration difference between boron and phosphorus in the i-type layer 4 on the basis of the result of the SIMS analysis shown in Fig. 7.

First, the position of the shoulder SD1a in the concentration distribution of phosphorus is specified by visual check. In Fig. 7, this position is defined as $x = X0$.

Subsequently, in the concentration distribution of phosphorus, the position where the phosphorus concentration first falls to the background level in the range of $x < X0$ when tracing of the profile is made toward the i-type layer 4 is specified by visual check. In Fig. 7, this position is defined as $x = X1$. There may be alternative case where the position of the shoulder SD2a in the concentration distribution of boron is defined as X0 and the position where the boron concentration first falls to the background level in the range of $x < X0$ when tracing of the profile is made toward the i-type layer 4 is defined as X1. Herein, if the values of X0 and X1 in the concentration distribution of phosphorus and the values of X0 and X1 in the concentration distribution of boron are different, values having larger absolute values are assumed to be the values of X0 and X1.

After the specification of the values of X0 and X1, the concentration difference $\Delta C$ between the boron concentration Cb and the phosphorus concentration Cp is calculated with respect to each point of all the analysis depth regions in the range of $X1 \le x \le X0$. Then, the arithmetic average value $\Delta Cav$ of all the concentration differences $\Delta C$ is obtained. The concentration difference arithmetic average value $\Delta Cav$ is used as the evaluation value indicating the concentration difference between boron and phosphorus. Though X0 and X1 are specified by visual check, for obtaining the concentration difference arithmetic average value $\Delta Cav$, the errors in the specification of the values of X0 and X1 may be hardly considered. Particularly, as to X1, since X1 is specified in a low-concentration area near the background, even if the specified position is somewhat out of the right position, almost no effect is produced on the concentration difference arithmetic average value $\Delta Cav$.

Even if the surface of the transparent conductive layer 2 has no structure of asperity, the concentration difference arithmetic average value $\Delta Cav$ can be obtained by the same procedure.

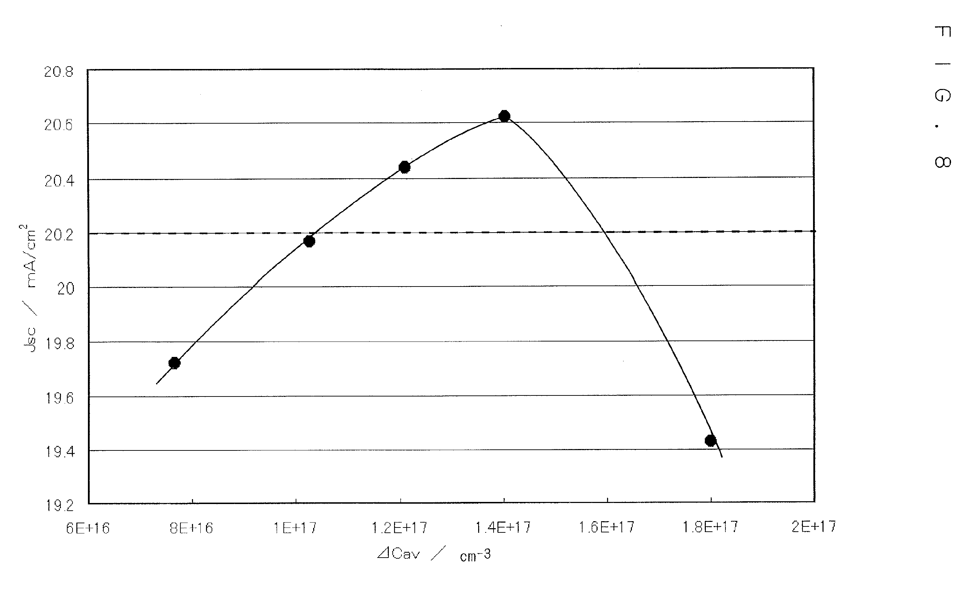

Fig. 8 shows a relation between the concentration difference arithmetic average value $\Delta Cav$ and the current density Jsc of a plurality of solar cell devices 10 which are processed by the first method of the n-type dopant introduction process, and manufactured under the conditions of the dilution rate of $PH_3$-$H_2$ mixed gas and the plasma processing time shown in Table 1. As shown in Fig. 8, the current density Jsc becomes the maximum at the point where the concentration difference arithmetic average value $\Delta Cav =$ about $1.4 \times 10^{17}$ (cm$^{-3}$). The maximum value of the current density Jsc is 20.6 mA/cm$^2$.

Table 1

| Supply of $PH_3$ (sccm) | Supply of $H_2$ (sccm) | Processing Time (sec) |
|---|---|---|
| 1 | 499 | 1 |
| 1 | 99 | 10 |
| 2 | 98 | 1 |
| 1 | 199 | 1 |
| 10 | 90 | 1 |

On the other hand, as a reference sample, a plurality of solar cell devices are manufactured under the same conditions as those of each point shown in Fig. 8 except that no n-type dopant introduction process is performed, and the current densities Jsc are evaluated. The average value of the current densities Jsc is about 20.2 mA/cm$^2$ (indicated by a broken line in Fig. 8). Considering the result together with the above result, a sufficient effect of increasing the current density Jsc can be produced when the n-type dopant introduction process is performed with the deposition of phosphorus on the surface of the transparent conductive layer 2 controlled so that the concentration difference arithmetic average value $\Delta Cav$ may fall in the range of $1.1 \times 10^{17}$ (cm$^{-3}$) $\le \Delta Cav \le 1.6 \times 10^{17}$ (cm$^{-3}$).

Herein, the concentration difference arithmetic average value $\Delta Cav$ has a direct correlation with the current density Jsc but depends on a plurality of condition parameters.

As to some of the solar cell devices, almost no shoulder of the peak for the specification of X0 is found in the result of the SIMS analysis. In such a case, used is the value of X0 of other solar cell devices which are manufactured under the same conditions. This is because the solar cell devices manufactured under the same conditions have almost the same thickness of each layer and almost the same diffusion behaviors of boron and phosphorus and it is thought that whether the shoulder is found or not depends on the difference of the appearance of asperity in the analysis region.

<Variations>

Though the analysis is performed on the superstrate type thin film solar cell in which the silicon thin film layer is formed of a-Si:H in the above-discussed preferred embodiment, the effect of increasing the characteristics, which is caused by the n-type dopant introduction process, can be also produced on a superstrate type thin film solar cell using a silicon thin film layer in an intermediate state where silicon films of a-Si:H and those of $\mu$c-Si are mixed, a hydrogenated amorphous silicon germanium (a-SiGe:H) thin film layer in which germanium is mixed in order to control the bandgap of the light absorption, or a hydrogenated amorphous silicon carbide (a-SiC:H) thin film layer. Further, the same effect as above can be produced also in a case where at least one of the p-type layer 3, the i-type layer 4, and the n-type layer 5 has a double layered structure constituted of a layer of a-Si:H and that of $\mu$c-Si:H.

In order to achieve higher-efficiency Si thin film solar cell, a tandem-type thin film solar cell may be manufactured, in which a p-i-n junction structure of a-Si:H is formed on the transparent substrate on the light incident side in accordance with the techniques of the above-discussed preferred embodiment and then a p-i-n junction structure of $\mu$c-Si having a narrow bandgap is formed thereon. Further, a triple tandem-type thin film solar cell of triple-junction type using SiGe and SiC may be manufactured.

EXAMPLES

(Example 1)

In this example 1, solar cell devices corresponding to five data points in Fig. 8 were obtained by performing the n-type dopant introduction process along the above-discussed first method.

First, prepared was a commercially available glass substrate having a surface on which a $SnO_2$ film was formed in advance. On the surface of the $SnO_2$ film, a structure of asperity, which was naturally created in the formation of the $SnO_2$ film by the thermal CVD method, had been formed with a height and an average cycle of asperities both of about 100 to 200 nm. The glass substrate has a square shape with each side of 100 mm in a plan view.

The glass substrate was placed on the cleaned tray 103 in the reaction chamber 101 of the parallel plate plasma CVD apparatus 100 and the n-type dopant introduction process was performed. Specifically, a voltage was applied thereto with a frequency of 13.56 MHz and electric power of 0.125 W/cm$^2$ to excite plasma, to thereby deposit phosphorus atoms serving as the n-type dopant on the $SnO_2$ film. At this time, the substrate temperature was 220 °C and the pressure in the reaction chamber 101 was 210 Pa.

In this example, in the plasma processing, the n-type dopant introduction process was performed under five conditions with the combinations of the $PH_3$ gas/$H_2$ gas flow rate ratio and the plasma processing time shown in Table 1.

On each of the five types of glass substrates having been subjected to the above n-type dopant introduction process, the p-type layer 3, the i-type layer 4, and the n-type layer 5 were formed in this order by the plasma CVD film formation apparatus 100. In this case, the n-type dopant introduction process and the following process of film formation of the p-type layer 3 and the like are sequentially performed, with the elements not being exposed to the atmosphere, in the plasma CVD film formation apparatus 100. Between the p-type layer 3 and the i-type layer 4, formed was the buffer layer having a thickness of about 5 nm.

The formation of the p-type layer 3 was performed by a process in which the high-frequency power supply 107 applied a plasma voltage to the upper electrode 104 with a frequency of 13.56 MHz and electric power of 0.025 W/cm$^2$ in a state where the inside of the reaction chamber 101 was vacuum-depressurized by the depressurization means 108 and $SiH_4$ gas, $H_2$ gas, $B_2H_6$ gas, and $CH_4$ gas each serving as a source gas were supplied thereto with flow rates of 10 sccm, 480 sccm, 40 sccm, and 20 sccm, respectively. At this time, the substrate temperature was 220 °C and the pressure in the reaction chamber 101 was 200 Pa. Further, the time for applying the plasma voltage was controlled so that the thickness of the p-type layer 3 may become 8 nm. The supply flow rates of the above gases was determined so that the atomic concentration of boron in the p-type layer 3 may become about 10$^{19}$ to 10$^{21}$ (cm$^{-3}$).

The formation of the i-type layer 4 was performed by a process in which the $SiH_4$ gas and the $H_2$ gas each serving as a source gas were supplied with flow rates of 50 sccm and 200 sccm, respectively, and the plasma voltage was applied so that the formation of the p-type layer 3 may be performed with a frequency of 13.56 MHz and electric power of 0.025 to 0.05 W/cm$^2$. At this time, the substrate temperature was 200 °C and the pressure in the reaction chamber 101 was 200 Pa. Further, the time for the film formation was controlled so that the thickness of the i-type layer 4 may become 300 nm.

The formation of the n-type layer 5, following the formation of the i-type layer 4, was performed by a process in which the $SiH_4$ gas, the $H_2$ gas, and $PH_3$ gas each serving as a source gas were supplied with flow rates of 10 sccm, 110 sccm, and 10 sccm, respectively, and the high-frequency power supply 107 applied the plasma voltage to the upper electrode 104 with a frequency of 13.56 MHz and electric power of 0.05 $W/cm^2$. At this time, the substrate temperature was 220 °C and the pressure in the reaction chamber 101 is 266 Pa. Further, the time for the film formation was controlled so that the thickness of the n-type layer 5 may become 20 nm. The supply flow rates of the above gases were determined so that the atomic concentration of phosphorus in the n-type layer 5 may become about $10^{19}$ to $10^{21}$ ($cm^{-3}$).

After the formations of the p-type layer, 3, the i-type layer 4, and the n-type layer 5 were completed, next, a transparent conductive layer and an Ag film serving as the electrode layer 6 were formed by a sputtering method in this order. The thickness of the transparent conductive layer is, for example, 10 nm and that of the Ag film is about 0.5 $\mu$m.

The current-voltage characteristics of the five solar cell devices which were manufactured through the above processes were measured by using a solar simulator, and the current densities Jsc were thereby obtained.

Further, on the above solar cell devices, performed was the SIMS (Secondary Ion Mass Spectrometry) analysis in the depth direction. One exemplary analysis result is shown in Fig. 4. This is the result on the solar cell device manufactured by the process in which the n-type dopant introduction process is performed with the $PH_3$ gas/$H_2$ gas flow rate ratio of 1/99 sccm and the plasma processing time of 1 sec. From the result of the SIMS analysis, it was verified that not only boron which had been doped for the formation of the p-type layer 3 but also phosphorus in the n-type dopant introduction process prior to the formation of the p-type layer 3 was diffused into a range on the side of the i-type layer 4 from the average start position of the tailing of boron.

Furthermore, the positions X0 and X1 were specified as shown in Fig. 7 and the arithmetic average value $\Delta Cav$ of the concentration difference between boron and phosphorus was obtained for each of the positions. The obtained concentration difference arithmetic average value $\Delta Cav$ and the current density Jsc were plotted, and the result shown in Fig. 8 were thereby obtained.

(Comparative Example 1)

Sixteen solar cell devices were manufactured under the same condition as that of the solar cell devices of which the analysis result was shown in Fig. 4 except that no n-type dopant introduction process was performed. The current-voltage characteristics of each of the solar cell devices were measured by using the solar simulator, and the current densities Jsc were thereby obtained. The current densities Jsc thereof and the average value are shown in Table 2.

Table 2

| Sample No. | Jsc (mA/cm$^2$) |
|------------|-----------------|
| 1 | 19.87 |
| 2 | 19.73 |
| 3 | 20.13 |
| 4 | 20.24 |
| 5 | 20.02 |
| 6 | 20.05 |
| 7 | 20.28 |
| 8 | 20.21 |
| 9 | 20.41 |
| 10 | 20.29 |
| 11 | 20.45 |
| 12 | 20.39 |
| 13 | 20.43 |
| 14 | 20.33 |
| 15 | 20.42 |

(continued)

| Sample No. | Jsc (mA/cm$^2$) |
|---|---|
| 16 | 20.11 |
| Average | 20.21 |

By comparing the result of example 1 and that of the comparative example 1, it was verified that a sufficient effect of increasing the current density Jsc can be produced when the n-type dopant introduction process was performed so that the concentration difference arithmetic average value $\Delta$Cav may fall in the range of $1.1 \times 10^{17}$ (cm$^{-3}$) $\leq \Delta$av $\leq 1.5 \times 10^{17}$ (cm$^{-3}$).

(Example 2)

In this example, the solar cell device 10 was obtained by performing the n-type dopant introduction process along the above-discussed second method.

First, like in the first preferred embodiment, a glass substrate having a surface on which a SnO$_2$ film was formed was prepared and the glass substrate was placed on the tray 103 in the reaction chamber 101 of the plasma CVD film formation apparatus 100. The tray 103 is an uncleaned one on which the p-i-n junction structure unit was formed in an antecedent process and that was served without cleaning. The tray 103 on which the glass substrate is placed has the margin region E around the glass substrate.

In this state, like in example 1, the p-type layer 3, the i-type layer 4, and the n-type layer 5 were formed in this order. After that, the electrode layer 6 was formed, like in example 1.

Under the same conditions, sixteen solar cell devices were manufactured, and the current-voltage characteristics of each of the solar cell devices were measured by using the solar simulator, and the current densities Jsc were thereby obtained.

Further, the SIMS analysis was performed on one of the solar cell devices, like in example 1. The result of this analysis is shown in Fig. 5. Also in example 2, like in example 1, it was verified that not only boron which had been doped for the formation of the p-type layer 3 but also phosphorus supplied in the n-type dopant introduction process prior to the formation of the p-type layer 3 was diffused into a range on the side of the i-type layer 4 from the average start position of the tailing of boron.

(The Comparative Example 2)

Sixteen solar cell devices were manufactured by the same procedure as that of the second preferred embodiment except that the cleaned tray was used instead of the uncleaned tray. The current-voltage characteristics of each of the solar cell devices were measured by using the solar simulator, and the current densities Jsc were thereby obtained.

Table 3 shows the current densities Jsc of the solar cell devices manufactured in the example 2 and the comparative example 2 as relative values with respect to the average value of the current densities Jsc of the sixteen solar cell devices in the second preferred embodiment which is assumed to be 100.

Table 3

| Sample No. | Second Preferred Embodiment | Second Comparative Example |
|---|---|---|
| 1 | 98.9 | 89.4 |
| 2 | 98.9 | 91.0 |
| 3 | 99.5 | 91.0 |
| 4 | 100.5 | 93.1 |
| 5 | 101.6 | 93.7 |
| 6 | 100.5 | 94.7 |
| 7 | 101.6 | 94.7 |
| 8 | 100.5 | 95.2 |
| 9 | 99.5 | 92.1 |

(continued)

| Sample No. | Second Preferred Embodiment | Second Comparative Example |
|---|---|---|
| 10 | 100.0 | 94.2 |
| 11 | 100.5 | 91.0 |
| 12 | 100.0 | 91.5 |
| 13 | 100.0 | 92.1 |
| 14 | 100.0 | 94.2 |
| 15 | 100.0 | 95.2 |
| 16 | 98.9 | 93.7 |
| Average | 100.0 | 93.1 |

From Table 3, it was verified that the effect of increasing the current density Jsc can be produced when the uncleaned tray is used like in the second preferred embodiment.

## Claims

1. A method of manufacturing a solar cell device, comprising:

   preparing a transparent substrate with a transparent conductive film;
   depositing an n-type dopant on said transparent conductive film; and
   sequentially forming a p-type layer, an i-type layer, and an n-type layer on said transparent conductive film.

2. The method of manufacturing a solar cell device according to claim 1, wherein
   said depositing said n-type dopant on said transparent conductive film comprises:

   plasmatizing an n-type dopant supply gas; and
   depositing said plasmatized n-type dopant on said transparent conductive film.

3. The method of manufacturing a solar cell device according to claim 2, wherein
   said n-type dopant supply gas is a gas obtained by $PH_3$ gas with $H_2$ gas.

4. The method of manufacturing a solar cell device according to claim 1, further comprising
   arranging said transparent substrate on a tray in a plasma CVD apparatus,
   wherein said depositing said n-type dopant on said transparent conductive film comprises:

   placing a phosphorus source in a region of said tray which is not covered with said transparent substrate;
   etching said phosphorus source with a plasma gas generated during the formation of said p-type layer;
   causing said plasma gas to contain phosphorus during the formation of said p-type layer; and
   depositing phosphorus on said transparent conductive film.

5. The method of manufacturing a solar cell device according to claim 4, wherein
   said phosphorus source is a phosphorus-containing member provided in said region of said tray which is not covered with said transparent substrate.

6. The method of manufacturing a solar cell device according to claim 4, wherein
   said phosphorus source is amorphous silicon doped with phosphorus.

7. The method of manufacturing a solar cell device according to any one of claims 1 to 6, comprising
   depositing said n-type dopant on said transparent conductive film so that an arithmetic average value $\Delta Cav$ of the concentration difference between boron and phosphorus within a range of diffusion of boron in said i-type layer, which is specified on the basis of a concentration distribution in a depth direction of said solar cell device, is expressed as;

$$1.1 \times 10^{17} \ (\mathrm{cm}^{-3}) \leq \Delta \mathrm{Cav} \leq 1.6 \times 10^{17} \ (\mathrm{cm}^{-3}).$$

8. A method of manufacturing a solar cell device, comprising:

manufacturing a first solar cell device comprising:

arranging a first transparent substrate on which a first transparent conductive film is formed on a tray in a plasma CVD apparatus;
depositing an n-type dopant on said first transparent conductive film and a region of said tray which is not covered with said first transparent substrate; and
sequentially forming a p-type layer, an i-type layer, and an n-type layer on said first transparent conductive film, and
manufacturing a second solar cell device after said manufacturing a first solar cell device comprising:

preparing a second transparent substrate on which a second transparent conductive film is formed;
arranging said second transparent substrate on said tray;
depositing an n-type dopant on said second transparent conductive film by using an n-type layer formed of amorphous silicon which is deposited on said region of said tray which is not covered with said first transparent substrate during the formation of said n-type layer of said first solar cell device; and
sequentially forming a p-type layer, an i-type layer, and an n-type layer on said second transparent conductive film.

9. A solar cell device, comprising:

a transparent substrate;
a transparent conductive film formed on said transparent substrate;
a p-type layer, an i-type layer, and an n-type layer each formed of amorphous silicon, which are stacked on said transparent conductive film,; and
a conductive layer formed on said n-type layer,
wherein an arithmetic average value $\Delta$Cav of the concentration difference between boron and phosphorus within a range of diffusion of boron in said i-type layer, which is specified on the basis of a concentration distribution in a depth direction of said solar cell device, is expressed as;

$$1.1 \times 10^{17} \ (\mathrm{cm}^{-3}) \leq \Delta \mathrm{Cav} \leq 1.6 \times 10^{17} \ (\mathrm{cm}^{-3}).$$

F I G . 1

10

IF ⟶

- 6
- 5
- 4
- 3
- 2
- 1

F I G . 2

F I G . 3

F I G . 4

F I G . 5

F I G . 6

(a)

(b)

# F I G . 7

F I G . 8

**INTERNATIONAL SEARCH REPORT**

| International application No. |
| --- |
| PCT/JP2009/052109 |

| A. CLASSIFICATION OF SUBJECT MATTER |
| --- |
| *H01L31/04(2006.01)i* |
| According to International Patent Classification (IPC) or to both national classification and IPC |

| B. FIELDS SEARCHED |
| --- |
| Minimum documentation searched (classification system followed by classification symbols) |
| H01L31/04 |
| Documentation searched other than minimum documentation to the extent that such documents are included in the fields searched |
| Jitsuyo Shinan Koho 1922-1996 Jitsuyo Shinan Toroku Koho 1996-2009<br>Kokai Jitsuyo Shinan Koho 1971-2009 Toroku Jitsuyo Shinan Koho 1994-2009 |
| Electronic data base consulted during the international search (name of data base and, where practicable, search terms used) |

| C. DOCUMENTS CONSIDERED TO BE RELEVANT | | |
| --- | --- | --- |
| Category* | Citation of document, with indication, where appropriate, of the relevant passages | Relevant to claim No. |
| A | JP 2000-277766 A  (Sanyo Electric Co., Ltd.),<br>06 October, 2000 (06.10.00),<br>Claim 3; Par. No. [0034]; Figs. 1 to 2<br>(Family: none) | 1-9 |
| A | JP 63-296381 A  (Mitsui Toatsu Chemicals, Inc.),<br>02 December, 1988 (02.12.88),<br>Page 2, upper left column; Fig. 1<br>(Family: none) | 1-9 |
| A | JP 4-369870 A  (Sanyo Electric Co., Ltd.),<br>22 December, 1992 (22.12.92),<br>Par. No. [0011]; Fig. 1<br>(Family: none) | 1-9 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>02 March, 2009 (02.03.09) | Date of mailing of the international search report<br>10 March, 2009 (10.03.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2009/052109 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 57-43477 A  (Sanyo Electric Co., Ltd.),<br>11 March, 1982 (11.03.82),<br>Page 2, upper right column<br>(Family: none) | 1-9 |
| A | JP 61-194880 A  (Fuji Electric Co., Ltd.),<br>29 August, 1986 (29.08.86),<br>Page 2, upper left column<br>(Family: none) | 1-9 |
| A | JP 62-200773 A  (Ricoh Co., Ltd.),<br>04 September, 1987 (04.09.87),<br>Page 2, upper right column; Fig. 2<br>(Family: none) | 1-9 |
| A | JP 4-167475 A  (Sanyo Electric Co., Ltd.),<br>15 June, 1992 (15.06.92),<br>Page 2, lower left column; Fig. 1<br>(Family: none) | 1-9 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 7263728 A
- JP 9223807 A
- JP 2004031518 A